# EUROPÄISCHE PATENTSCHRIFT

(11) **EP 1 006 558 B1**
(45) Veröffentlichungstag und Bekanntmachung des Hinweises auf die Patenterteilung: **09.04.2003**
(21) Anmeldenummer: 99121195.4
(22) Anmeldetag: 23.10.1999
(51) Int. Cl.: H01J 37/34, C23C 14/34

(54) **Zerstäubungskathode für die Beschichtung von Substraten**
Sputtering cathode for substrate deposition
Cathode de pulvérisation pour dépôt sur un substrat

(30) Priorität: 03.12.1998 DE 19855726
(43) Veröffentlichungstag der Anmeldung: 07.06.2000
(73) Patentinhaber: Unaxis Deutschland Holding GmbH, 63450 Hanau (DE)
(72) Erfinder: Schuhmacher, Manfred, 63755 Alzenau (DE); Joos, Gerhard, 63843 Niedernberg (DE); Winter, Erwin, 63456 Hanau (DE)

(56) Entgegenhaltungen:
- DE-A- 4 242 079

## Beschreibung

Die Erfindung betrifft eine Zerstäubungskathode für die Beschichtung von Substraten mit dünnen Schichten, insbesondere von Indium-Zinn-Oxyd-Targets, umfassend eine am Kathodengrundkörper befestigte Targetgrundplatte mit einem das plattenförmige Target zumindest teilweise umschließenden mit der Targetgrundplatte verbundenen Rahmen.

Bekannt ist ein Target für die in einer evakuierbaren, mit einem Prozeßgas füllbaren Prozeßkammer angeordneten Kathode einer Vorrichtung zum Beschichten von Werkstücken (DE-OS 42 42 079) mit einem Kathodenkörper und mit einer Vielzahl auf dem Kathodenkörper in einer Reihe nebeneinanderliegend angeordneten, zueinander das Target bildenden Targetkacheln und mit mindestens einer zwischen den Targetkacheln und dem Kathodenkörper angeordneten Targetgrundplatte, wobei die aus dem abzusputternden Werkstoff gebildeten Targetkacheln jeweils eine parallelepipede Konfiguration aufweisen und jeweils fest mit einer ähnlich dimensionierten Targetgrundplatte verlötet, verschweißt oder verklebt sind, wobei die Grundflächen der Targetgrundplatten in ihrer Länge geringfügig kleiner und in ihrer Breite geringfügig größer bemessen sind, als die Grundfläche der jeweils zugehörigen Targetkachel, wobei die in der Breite jeweils über den Rand der Targetkachel hervorstehenden beiden Randpartien der Targetgrundplatte mit Hilfe von Pratzleisten fest am Kathodenkörper gehalten sind.

Diese bekannte Zerstäubungskathode hat den Nachteil hoher Temperaturempfindlichkeit, was erfahrungsgemäß dazu führt, daß der Kleber (bei Indium-Zinn-Oxyd-Targets) im Beschichtungsprozeß bereits bei geringer Temperaturüberschreitung die Kacheln nicht mehr trägt, so daß diese von der Targetgrundplatte abfallen und dabei zerstört werden.

Der vorliegenden Erfindung liegt die Aufgabe zugrunde, eine Kathode zum Warmsputtern zu schaffen, die mit einem sehr bruchempfindlichen und sprödem Targetwerkstoff ausgerüstet eine hohe Standzeit und eine hohe Betriebssicherheit ermöglicht.

Diese Aufgabe wird erfindungsgemäß dadurch gelöst, daß die dem Target zugekehrte Seitenfläche des Rahmens mit der dieser gegenüberliegenden Seitenfläche des Targets zumindest abschnittsweise verklebt ist, wobei die Seitenfläche des Rahmens um einen Winkel von etwa 2° bis 5° gegenüber der korrespondierenden Seitenfläche des Targets geneigt ausgebildet ist und der zwischen Targetgrundplatte, Rahmenseitenfläche und Targetseitenfläche gebildete Hohlraum mit etwa dreieckigem Querschnittsprofil mit Kleber gefüllt ist und die Rahmenseitenfläche sich zu einer Fase parallel erstreckt, die an der Kante vorgesehen ist, die die Seitenfläche des Targets mit der Oberseite des Targets bildet, wobei die obere, von der Seitenfläche des Rahmens und ihrer Oberseite gebildeten Kante des Rahmens und ihrer Oberseite gebildeten Kante sich um ein geringes Maß bis über eine Linie erstreckt, die die Targetseitenfläche mit der Targetgrundfläche bildet.

Weitere Merkmale und Einzelheiten sind in den Unteransprüchen beschrieben und gekennzeichnet.

Die Erfindung läßt die verschiedensten Ausführungsmöglichkeiten zu, eine davon ist in den anhängenden Zeichnungen schematisch dargestellt, die einen Längsschnitt durch die Kathode und zwei Detailschnitte zeigen.

Die Kathode besteht im wesentlichen aus einem wannenförmigen Kathodengrundkörper 3 mit einem etwa U-förmigen Querschnittsprofil; einer in den länglichen Kathodengrundkörper 3 eingelegten und mit diesem verschraubten Stützleiste 4, die mit dem wannenförmigen Kathodengrundkörper 3 einen ringförmigen Graben 5 bildet; einer auf dem umlaufenden Randteil des Kathodengrundkörpers 3 und dem Stützkörper 4 aufliegenden Targetgrundplatte 6, wobei zwischen Targetgrundplatte 6 und dem Kathodengrundkörper 3 noch eine dünne Kupfermembrane 7 ein Edelstahldrahtgewebezuschnitt 8 und ein Eisenblechzuschnitt 19 eingefügt sind; einem auf die Targetgrundplatte 6 aufgelegten ringförmigen plattenartigen Target 9, einem mit dem Kathodengrundkörper 3 verschraubten Pratzring 10; einem mit der Targetgrundplatte 6 verschraubten Rahmen 12; einem ebenfalls mit der Targetgrundplatte 6 verschraubten Steg 11 und einem in den Graben 5 eingelegten und mit dem Kathodengrundkörper 3 verschraubten Magnetjoch 13 mit den Magneten oder Magnetreihen 14, 15, 16.

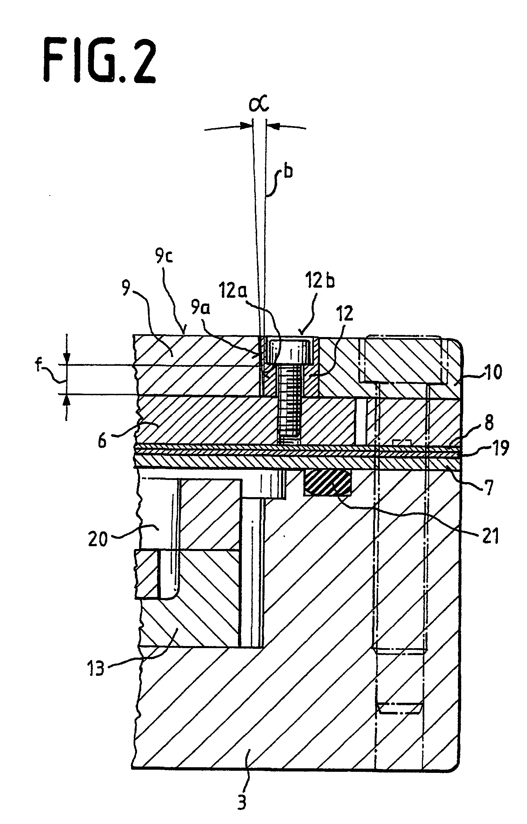

Der mit der Targetgrundplatte 6 verschraubte Rahmen 12 weist (ebenso wie der Mittelsteg 11) einen etwa rechtwinkligen Querschnitt auf (siehe Fig. 2), wobei die jeweils dem Target 9 zugewandte Seitenfläche 12a (bzw. 11a) eine von der Vertikalen b um einen Winkel α von etwa 2° bis 5° abweichende Neigung besitzt.

Die geneigte Fläche 12a des Rahmens 12 hat zu der an diese Fläche 12a angrenzenden Targetseitenfläche 9a einen Abstand, der den Übergang von der Oberseite 9c des Targets 9 zur Oberseite 12b des Rahmens 12 praktisch spaltfrei erscheinen läßt bzw. im Bereich dieses Übergangs einen bestimmten Formschluß bewirkt.

Um sicherzustellen, daß das Target 9 sich während des Sputtervorgangs nicht von der Targetgrundplatte 6 löst, ist die Targetgrundplatte 6 mit ihrer umlaufenden vertikalen Seitenfläche 9a mit den geneigten Seitenflächen 12a, 11a des Mittelstegs 11 bzw. des Rahmens 12 verklebt und zwar nur bis etwa zur halben Höhe f des Targets 9. Da diese Klebeverbindung zwischen der vertikalen Seitenfläche 9a des Targets 9 einerseits und der nahezu vertikalen Seiteninnenfläche 12a des Rahmens 12 auf Scherung beansprucht wird, wenn die Kathode mit ihrem Target 9 nach unten liegend betrieben wird, reicht diese schmale Klebefläche f aus, um die feste Verbindung zur Targetgrundplatte 6 zu erhalten.
Für den Fall, daß dennoch eine außerplanmäßige Überhitzung des Targets während des Sputtervorgangs erfolgen sollte, sorgt die spaltfreie, formschlüssige Verbindung zwischen dem Rahmen 12 und dem Mittelsteg 11 einerseits und dem Target 9 andererseits aus, um ein vollständiges Lösen bzw. Abfallen des Targets 9 von der Targetgrundplatte 6 zu verhindern.

Als Kleber hat sich ein kupfergefüllter Epoxy-Zweikomponentenkleber bewährt, der bis zu Temperaturen von 425°C (degration temp.) beständig ist.

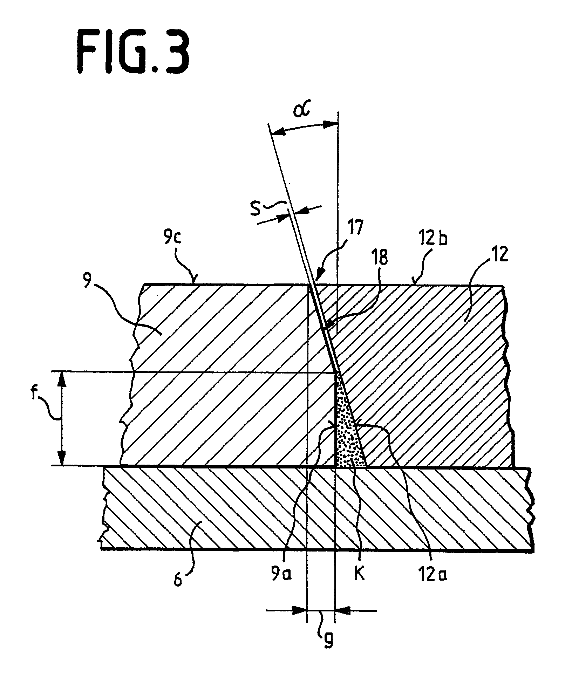

In Fig. 3 ist skizzenhaft und in sehr stark übertriebener, rein schematischer Art der Klebebereich bzw. der Berührungsbereich zwischen dem Target 9 und dem Rahmen 12 im Schnitt dargestellt. Wie diese Darstellung zeigt, befindet sich zwischen den Teilen 9 und 12 ein sehr schmaler Spalt S, der gerade eben einen unmittelbaren Kontakt zwischen beiden Teilen 9, 12 ausschließt, der jedoch bei Temperaturüberschreitung, d. h. beim Weichwerden des Klebers K das Target 9 auffängt und vor dem Abfallen bewahrt und damit eine Zerstörung des kostspieligen (ITO) stoßempfindlichen Targets verhindert.

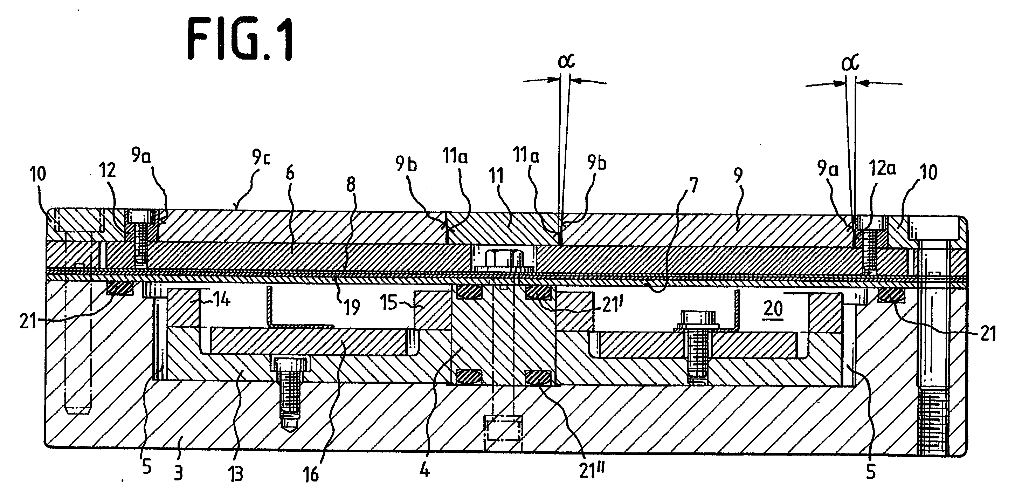

Bei der in Fig. 1 dargestellten Kathode sind das Target 9 aus Indium-Zinn-Oxyd, die Targetgrundplatte 6 aus Titan, die Pratzleiste 10 aus Edelstahl, der Rahmen 12 aus Titan und der Steg 11 ebenfalls aus Titan gebildet.

Der zwischen der Targetgrundplatte 6 und dem Blechzuschnitt aus Eisen 19 eingelegte Zuschnitt besteht aus einem Edelstahlgewebe und die Membrane 7 aus Kupfer. Der vom Kathodenkörper 3 und der Stützleiste 4 gebildete Ringkanal 20 ist von einem Kühlmittel durchströmt, wobei Dichtringe 21, 21',... vorgesehen sind, die den Ringkanal 20 gegenüber der Folie 7 bzw. dem Kathodengrundkörper 3 gegen den Austritt von Kühlmittel abdichten.

### Bezugszeichenliste

- 03: Kathodengrundkörper
- 04: Stützleiste
- 05: Graben
- 06: Targetgrundplatte
- 07: Folie
- 08: Edelstahldrahtgewebezuschnitt
- 09: Target
- 11: Steg
- 12: Rahmen
- 13: Magnetjoch
- 14: Magnetreihe
- 15: Magnetreihe
- 16: Magnetreihe

## Patentansprüche

1. Zerstäubungskathode für die Beschichtung von Substraten mit dünnen Schichten insbesondere von Indium-Zinn-Oxyd-Targets (9), umfassend eine am Kathodengrundkörper (3) befestigte Targetgrundplatte (6) mit einem das plattenförmige Target (6) zumindest teilweise umschließenden, mit der Targetgrundplatte (6) verbundenen Rahmen (12), **dadurch gekennzeichnet, daß** die dem Target (9) zugekehrte Seitenfläche (12a) des Rahmens (12) mit der dieser gegenüberliegenden Seitenfläche (9a) des Targets (9) zumindest abschnittsweise verklebt ist, wobei die Seitenfläche (12a) des Rahmens (12) um einen Winkel (α) von etwa 2° bis 5° gegenüber der korrespondierenden Seitenfläche (9a) des Targets (9) geneigt ausgebildet ist und der zwischen Targetgrundplatte (6), Rahmenseitenfläche (12a) und Targetseitenfläche (9a) gebildete Hohlraum mit etwa dreieckigem Querschnittsprofil mit Kleber (K) gefüllt ist und die Rahmenseitenfläche (12a) sich zu einer Fase (18) parallel erstreckt, die an der Kante vorgesehen ist, die die Seitenfläche (9a) des Targets (9) mit der Oberseite (9c) des Targets (9) bildet, wobei die obere von der Seitenfläche (12a) des Rahmens (12) und ihrer Oberseite (12b) gebildete Kante (17) um ein Maß (g) bis über eine Linie hervorsteht, die die Targetseitenfläche (9a) mit der Targetgrundplatte (6) bildet.

2. Zerstäubungskathode nach Anspruch 1, **dadurch gekennzeichnet, daß** die dem Target (9) zugekehrten Seitenflächen (11a) des mit der Stützleiste (4) oder der Targetgrundplatte (6) fest verbundenen Stegs (11) um einen Winkel (α) von etwa 2° bis 5° zu den korrespondierenden Targetseitenflächen (9b) des Targets (9) geneigt ausgebildet sind, wobei die der Targetgrundplatte (6) abgekehrte umlaufende Kante sich parallel einer Fase des Targets (9) erstreckt und der von den korrespondierenden Seitenflächen (11a, 9b) gebildete Spalt mit etwa dreieckiger Querschnittsfläche zumindest teilweise mit einem Kleber (K) ausgefüllt ist.

3. Zerstäubungskathode nach den Ansprüchen 1 und 2, **dadurch gekennzeichnet, daß** der zwischen den korrespondierenden Seitenflächen (9a, 12a bzw. 11a, 9b) des Rahmens (12) bzw. des Stegs (11) einerseits und des Targets (9) andererseits jeweils im Bereich der Fasen (18,...) des Targets (9) vorgesehene Spalt (S) so bemessen ist, daß die Breite der Spalte (S) etwa der Wärmedehnung des Targets (9) entspricht.

## Claims

1. Sputter cathode for the coating of substrates with thin layers, particularly indium-tin-oxide targets (9), comprising a target base plate (6) attached to the cathode base body (3) with a frame (12) at least partially surrounding the panel-shaped target (6) and attached to the target base plate (6), **characterised in that** the side surface (12a) of the frame (12) facing towards the target (9) is cemented at least in sections to the side surface (9a) of the target (9) lying opposed to it, whereby the side surface (12a) of the frame (12) is formed inclined at an angle (α) of between approximately 2° and 5° relative to the corresponding side surface (9a) of the target (9) and the hollow space of approximately triangular cross-sectional profile formed between the target base plate (6), the frame side surface (12a) and the target side surface (9a) is filled with adhesive (K) and the frame side surface (12a) extends parallel to a chamfer (18), which is provided on the edge which forms the side surface (9a) of the target (9) with the upper side (9c) of the target (9), whereby the upper edge (17) formed by the side surface (12a) of the frame (12) and its upper side (12b) projects by an amount (g) beyond a line formed by the target side surface (9a) with the target base plate (6).

2. Sputter cathode according to Claim 1, **characterised in that** the side surfaces (11a) facing towards the target (9) of the web (11) firmly attached to the supporting strip (4) or the target base plate (6) are formed inclined by an angle (α) of between approximately 2° and 5° relative to the corresponding side surfaces (9b) of the target (9), whereby the surrounding edge facing away from the target base plate (6) extends parallel to a chamfer of the target (9) and the gap of approximately triangular cross-sectional area formed by the corresponding side surfaces (11a, 9b) is at least partially filled with an adhesive (K).

3. Sputter cathode according to Claims 1 and 2, **characterised in that** the gap (S) provided between the corresponding side surfaces (9a, 12a or 11a, 9b) of the frame (12) or of the web (11), on the one hand, and of the target (9), on the other hand, in the region of the respective chamfers (18,...) of the target (9) is so dimensioned that the width of the gap (S) approximately corresponds to the thermal expansion of the target (9).

## Revendications

1. Cathode de pulvérisation pour le revêtement de substrats avec des couches minces, en particulier de cibles en oxyde d'indium et d'étain (9), comprenant une plaque de base de la cible (6) qui est fixée sur le corps de base de la cathode (3) et qui comporte un cadre (12) qui est relié à la plaque de base de la cible (6) et qui entoure, au moins partiellement la cible en forme de plaque (6) **caractérisé en ce que** la surface latérale (12a) du cadre (12) qui est dirigée vers la cible (9) est collée, au moins par sections, avec la surface latérale (9a) de la cible (9) qui est opposée à la surface latérale (12a), **en ce que** la surface latérale (12a) du cadre (12) est conformée avec une inclinaison selon un angle (α) compris entre environ 2 ° et 5 °par rapport à la surface latérale (9a) correspondante de la cible (9), **en ce que** l'espace creux, qui est formé entre la plaque de base de la cible (6), la surface latérale du cadre (12a) et ta surface latérale (9a) de la cible et dont la section transversale a un profil sensiblement triangulaire, est rempli avec de la colle (K), **en ce que** la surface latérale (12a) du cadre s'étend parallèlement à un chanfrein (18) qui est prévu sur l'arête qui forme, avec la face supérieure (9c) de la cible (9), la surface latérale (9a) de la cible (9), et **en ce que** l'arête supérieure (17), qui est formée par la surface latérale (12a) du cadre (12) et sa face supérieure (12b), fait saillie d'une grandeur (g) au-dessus d'une ligne qui forme la surface latérale (9a) de la cible avec la plaque de base de la cible (6).

2. Cathode de pulvérisation selon la revendication 1, **caractérisé en ce que** les surfaces latérales (11a) de la traverse (11) qui est reliée de manière fixe avec la barrette de protection (4) ou avec la plaque de base de la cible (6), qui sont dirigées vers la cible (9), sont conformées avec une inclinaison selon un angle (α) compris entre environ 2 ° et 5 °par rapport aux surfaces latérales correspondntes de cible (9b) de la cible (9), **en ce que** l'arête périphérique qui est opposée à la plaque de base de la cible (6) s'étend parallèlement à un chanfrein de la cible (9) et **en ce que** l'intervalle, qui est formé par les faces latérales (11a, 9b) correspondantes et dont la surface transversale est sensiblement triangulaire, est rempli, au moins partiellement, avec une colle (K).

3. Cathode de pulvérisation selon les revendications 1 et 2, **caractérisé en ce que** l'intervalle (S) qui est prévu entre les faces latérales correspondantes (9a, 12a ou 11a, 9b) du cadre (12) ou de la traverse (11), d'une part, et de la cible (9), d'autre part, à chaque fois dans la zone des chanfreins (18,...) de la cible (9), est dimensionné de telle manière que la largeur de l'intervalle (S) correspond sensiblement à la dilatation thermique de la cible (9).
